# EUROPEAN PATENT SPECIFICATION

(11) **EP 4 007 925 B1**
(45) Date of publication and mention of the grant of the patent: **02.10.2024**
(21) Application number: 20754532.8
(22) Date of filing: 24.07.2020
(51) Int. Cl.: G01R 19/155, H05K 5/02

(54) **A METHOD FOR ALLOWING ACCESS TO AN ELECTRICAL ENCLOSURE**
VERFAHREN ZUM ERMÖGLICHEN EINES ZUGRIFFS AUF EIN ELEKTRISCHES GEHÄUSE
PROCÉDÉ POUR PERMETTRE L'ACCÈS À UNE ENCEINTE ÉLECTRIQUE

(30) Priority: 02.08.2019 US 201962882042 P
(43) Date of publication of application: 08.06.2022
(73) Proprietor: Panduit Corp., Tinley Park, Illinois 60487 (US)
(72) Inventor: BUGARIS, Rachel M., Lexington, Kentucky 40509 (US); SENESE, John C., Naperville, Illinois 60565 (US)
(74) Representative: Roberts, Gwilym Vaughan
(86) International application number: PCT/US2020/043437
(87) International publication number: WO 2021/025873

(56) References cited:
- WO-A1-2015/152874
- CN-A- 108 205 107
- US-A- 5 027 057
- US-A1- 2015 048 814
- US-A1- 2015 077 122
- BUGARIS RACHEL M: "Improving Electrical Safety in the Workplace: Applying Prevention Through Design to Voltage Testing", IEEE INDUSTRY APPLICATIONS MAGAZINE, IEEE SERVICE CENTER, PISCATAWAY, NJ, US, vol. 23, no. 3, 1 May 2017 (2017-05-01), pages 12 - 23, XP011645395, ISSN: 1077-2618, [retrieved on 20170410], DOI: 10.1109/MIAS.2016.2600724
- PANDUIT: "VeriSafe Absence of Voltage Tester", 1 March 2016 (2016-03-01), pages 1 - 15, XP055428292, Retrieved from the Internet <URL:www.panduit.com/verisafe> [retrieved on 20171123]
- CRAWFORD K ET AL: "Test before touch", IEEE INDUSTRY APPLICATIONS MAGAZINE, IEEE SERVICE CENTER, PISCATAWAY, NJ, US, vol. 14, no. 3, 1 May 2008 (2008-05-01), pages 32 - 39, XP011226342, ISSN: 1077-2618, DOI: 10.1109/MIAS.2008.918503

## Description

### Cross Reference to Related Applications

This application claims benefit to U.S. Provisional Patent Application No. 62/882,042 filed on August 2, 2019.

### Field Of the Invention

The present invention relates generally to electrical disconnects and more specifically electrical disconnects incorporating absence of voltage testers.

### Background

In an industrial environment, electrical equipment is often housed within a panel, cabinet, or other type of enclosure. Equipment ranging from power components (e.g., switches, circuit breakers, fuses, drives, contacts, etc.) toho control and network products (e.g., PLCs, controllers, network switches, and power supplies, etc.) are often enclosed not only to provide protection from harsh or dynamic environments, but also to provide various levels of safety and security. Unauthorized access to an electrical, control, or network panel, whether intentional or unintentional, can lead to various hazards depending on the application especially if the electrical components are energized.

In recent years there has been an increased emphasis on electrical safety in the workplace with efforts to promote awareness of shock, arc flash, and arc blast hazards. When working on or near electrical equipment, hazards such as arc flash, arc blast, and electrical shock exist when voltage is present. OSHA enforces electrical safety via the general duty clause, relying heavily on content in voluntary consensus standards such as NFPA 70E, the Standard for Electrical Safety in the Workplace. With each revision of NFPA 70E, it is becoming less and less acceptable to perform tasks on energized equipment. In most cases, work involving electrical hazards is required to be performed in an electrically safe work condition (e.g., de-energized state). However, NFPA 70E also recognizes that some diagnostics and testing activities must be performed while the equipment is energized.

With industrial facilities become increasingly automated and networked, diagnostic activities have become more sophisticated. In many cases, startup configuration, troubleshooting, and testing of devices can be performed with only control/network power. It is generally accepted that lower voltages are less hazardous with regards to both electrical shock and arc flash. NFPA 70E Article 130(A)(3) specifically indicates that energized work on equipment rated less than 50V can be permitted. In industrial automation, control/network functions typically run at lower voltage levels (24Vdc). Thus, for many applications it is beneficial to have a separate infrastructure for control/network power within the panel that is not derived from the main power so that the main power source can be locked out while control/network power is available while certain tasks are performed.

Advances in technology have made personnel badging and access readers commonplace in many enterprise settings. Many industrial facilities also have measures in place to restrict and monitor access to various departments, laboratory, or production areas. These systems often run on network power or control voltage <50V. As power and control systems become intelligent with network capabilities, the lines between IT staff, electricians, and controls engineers are becoming blurred. With power, control, and network equipment all housed in similar enclosures, it is likely that someone who is unqualified to work on a particular type of equipment could try to access a panel creating hazards for him or herself, surrounding people, the equipment, or process - particularly in high pressure situations such as unplanned outages or situations where schedule delays must be avoided.

Additionally, the use of voltage indicators has become increasingly popular in industrial applications. Voltage indicators are typically hardwired to the load side of a circuit breaker or disconnect and use a series of LEDs to indicate when voltage is present in a panel or compartment. Powering a voltage detection and indication system via a separate source enables the sensor to actively indicate when voltage is not present. The embodiment of this installed voltage test device could include an optional output, for example dry contacts, which could be used to convey the results of the voltage test to another system.

When an enclosure is outfitted with a voltage detector, enclosure lock, controller, and optional credential reader (all powered independently from the main power circuit) new methods to address the safety, security, and maintenance problems that occur in industrial facilities are possible. Often, these elements do not exist or if a subset is present in an enclosure, they function independently. The new concept described herein, presents an opportunity to solve some of these problems by presenting a new method to usher in the next generation of safety to security and maintenance practices.

Unauthorized access to an electrical, control, or network panel, whether intentional or unintentional, can lead to safety and security hazards that may affect people, equipment, or process. Using an access control system at the enclosure level that includes an electronic lock in conjunction with a credential reader users can control or restrict access to authorized people at authorized times. By powering the controller, lock, and credential reader via a non-hazardous source or energy storage device separate from the primary power (such as the network (PoE), battery, ultracap, etc.), voltage is limited to a safe level (50V or less) and the devices will continue to function as long as the secondary power is available, regardless of the status of the main/primary power sources within the enclosure. To further reduce risk, it may be desirable in some cases to further restrict access to situations only when the panel has been de-energized, or if special circumstances have been met (e.g., completion of an energized work permit). Thus, incorporating a voltage detection system is also essential.

### Summary

A method for allowing access to an electrical enclosure having a disconnect includes upon initiation by a user or upon a change of state of the disconnect automatically performing the steps of checking for an absence of voltage, giving a positive indication of an absence of voltage, checking the state of each phase of the eletrical disconnect to ensure contacts of the disconnect are open, and if there is an absence of voltage and the contacts of the disconnect are open opening a lock on the enclosure

XP011645395, BUGARIS RACHEL M, relates to "Improving Electrical Safety in the Workplace: Applying Prevention Through Design to Voltage Testing". The document discloses a method for allowing access to an electrical enclosure comprising checking for absence of voltage and if there is an absence of voltage, opening a lock on the enclosure.

US 2015/048814 relates to a system for the detection and indication of both the absence and presence of voltage. The system has a voltage detector module, a voltage indicator module, and a communication network based continuous secondary power source configured to enable the voltage indicator module to positively indicate the absence of voltage in the primary circuit such that the positive detection and indication is powered by the primary circuit itself. In some embodiments, the positive detection and indication of voltage can also be powered by the communication network based secondary power source.

WO 2015/152874 relates to a monitoring system for monitoring a status of current supply through a current supply conductor in an electrical housing. A current transformer and a monitoring circuit monitor the conductor in the housing. The monitoring circuit is powered by current induced in the transformer from current in the conductor. The monitoring circuit is configured to output a signal on an output line indicating whether the current in the conductor is on or off. The monitoring circuit is connected to at least one of a display device and a door interlock of a door of the housing to, respectively, indicate whether the current in the conductor is on or off and to prevent the door of the housing from opening when the signal on the output line indicates that the current is on.

XP055428292 relates to "VeriSafe Absence of Voltage Tester".

US 5 027 057 relates to an input condition sensing circuit for use in a facility management system which is selectively operable in a first mode for sensing the presence or absence of a voltage potential or a second mode for sensing a high or low impedance and which provides a binary output signal indicative of the condition being sensed and an amplifier coupled to the input for generating a control signal having an amplitude relating to the input condition being sensed. The circuit also includes detecting means coupled to the amplifier for providing a binary output in response to the control signal and indicative of the condition being sense and select means coupled to the detecting means for selectively conditioning the circuit for operating in either the first or second mode. The select means is arranged to cause the detecting means to provide a first binary output state in response to sensing the presence of a voltage while the first operating mode and a cause the detecting means to provide a different binary output state in response to sensing a high impedance while in the second operating mode.

CN 108 205 107 relates to a switch contact state detection-display device and method. A contact state of an electrical switch is detected by an electronic circuit, input to a processor for interpretation, and then displayed outside the switch. The electronic circuit is designed in the device and electrically connected to the primary and secondary side of the switch, a sensed signal is sent to the microprocessor, determination is made according to set motion state logics, the state is displayed in a corresponding lamp number, and a user can know the real state of the switch contact via the lamp number.

US 2015/077122 relates to a safety device capable of being connected between a circuit breaker device and an electric installation powered by an electric grid providing three-phase current having a first associated frequency, using a line for conveying electric current including three phase conductors (PH1, PH2, PH3_, a neutral conductor (N) and a protection conductor (PE). This device makes it possible to verify at least one electric safety condition following a cut off of electric power of the electric installation by the circuit breaker device. This device comprises means for verifying the presence of a residual voltage above a predetermined safety threshold on at least one of the conductors and means for verifying isolation between two conductors of at least one pair of conductors, called the tested pair of conductors, among said phase conductors. The invention also relates to an associated safety verification method carried out by an associated safety device.

XP011226342, CRAWFORD K ET AL relates to "Test before touch' and concerns methods of testing for absence of voltage. In one embodiment, it also discloses to perform a visual inspection that some switchblades or contacts are in an open position

### Brief Description of the Drawings

Fig. 1 shows an absence of voltage tester (AVT) added to an electrical enclosure.
Fig. 2 shows an AVT added to an electrical disconnect as an additional component.
Fig. 3 shows an AVT incorporated into an electrical disconnect.
Fig. 4 shows a situation where a dangerous condition can occur if one or more phases of a disconnect is not mechanically disengaged even if the disconnect is locked out.
Fig. 5 shows an application where an AVT with disconnect verification coud be used.
Fig. 6 shows a sequential method of implementing the disconnect verification in combination with an AVT.

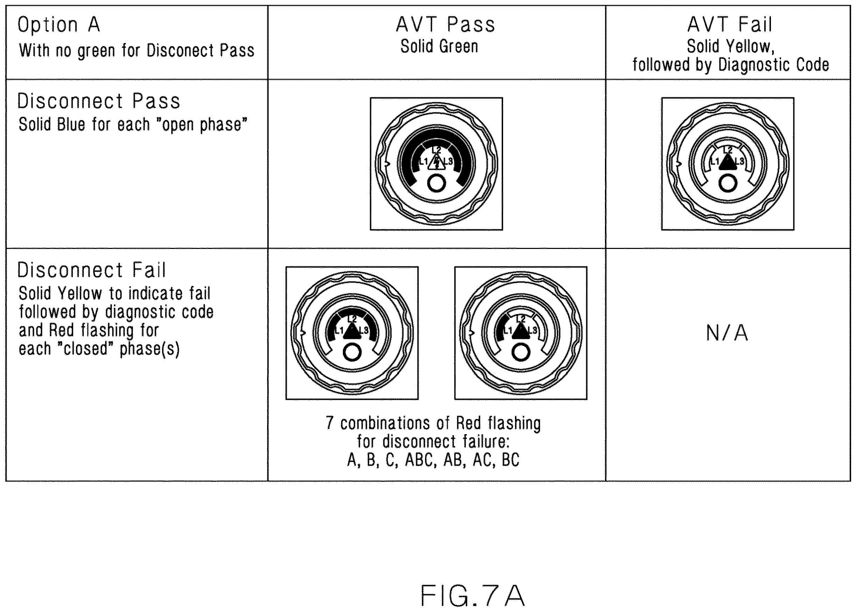

Fig. 7a shows a first chart showing various pass/fail indications of an AVT incorporated into a disconnect in a sequential system.

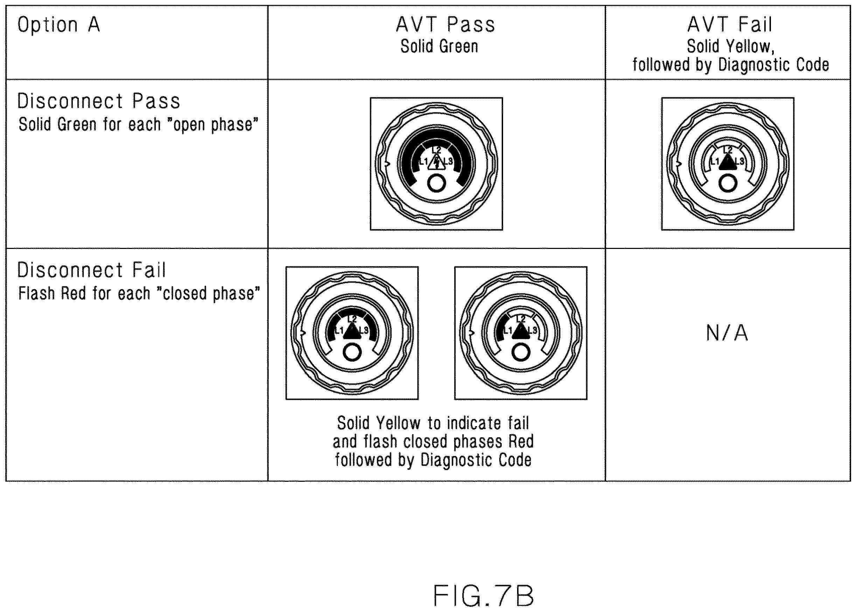

Fig. 7b shows a second chart showing various pass/fail indications of an AVT incorporated into a disconnect in a sequential system.
Fig. 8 shows a parallel method of incorporating the disconnect verification in combination with an AVT.

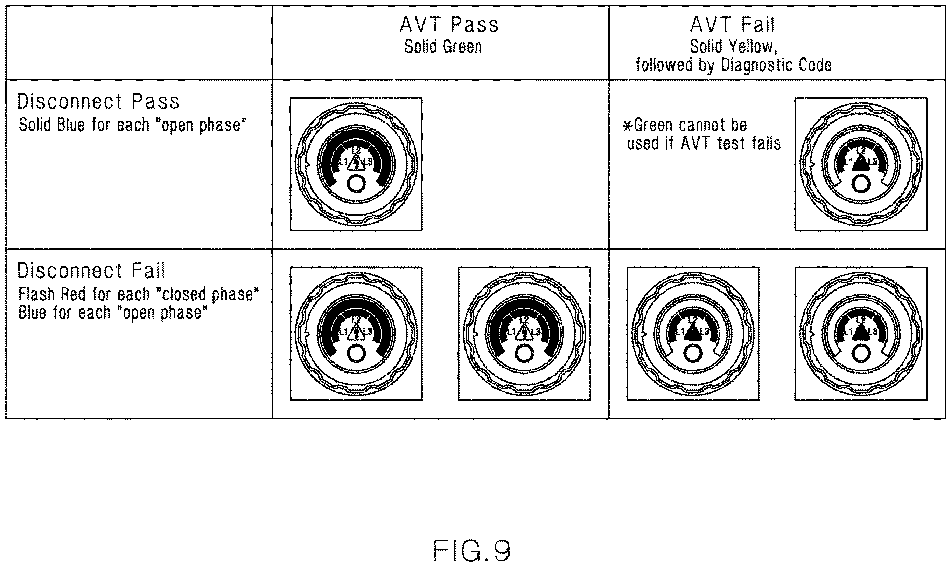

Fig. 9 shows a chart showing various pass/fail indications of an AVT incorporated into a disconnect in a parallel system.

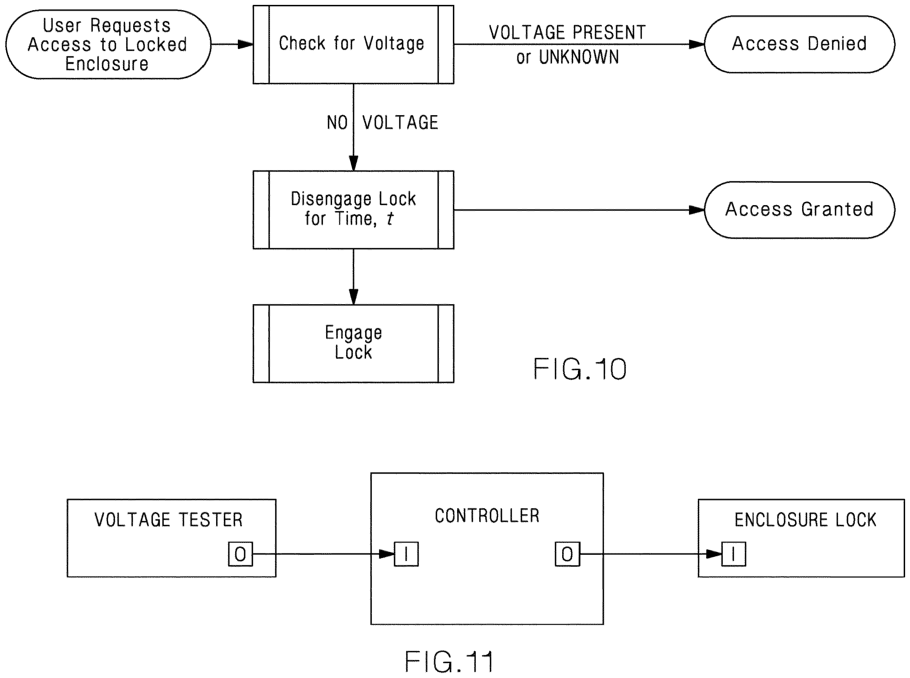

Fig. 10 is a method showing a basic process of using voltage status to control access to an enclosure.
Fig. 11 shows the basic input and outout relationship of the system of Fig. 10.

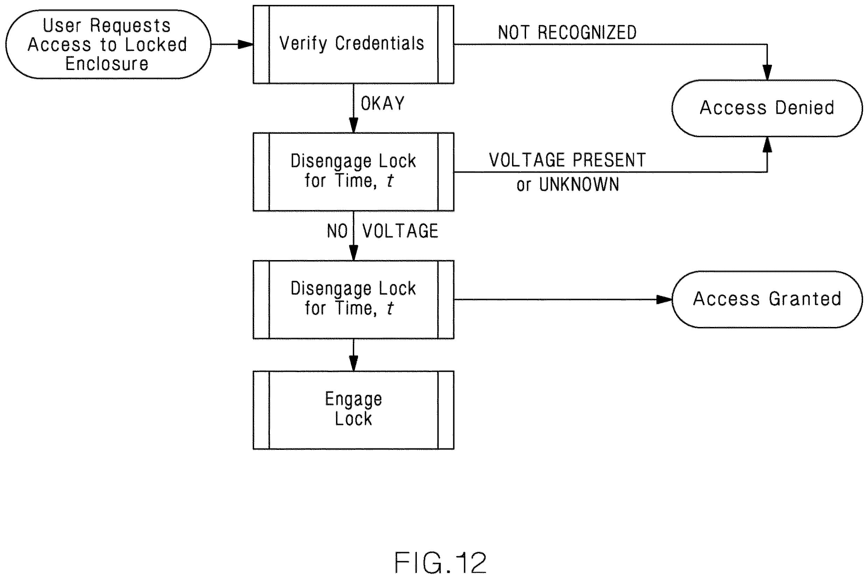

Fig. 12 shows the basic process for using status of voltage to access to an enclosure with credential authentication.

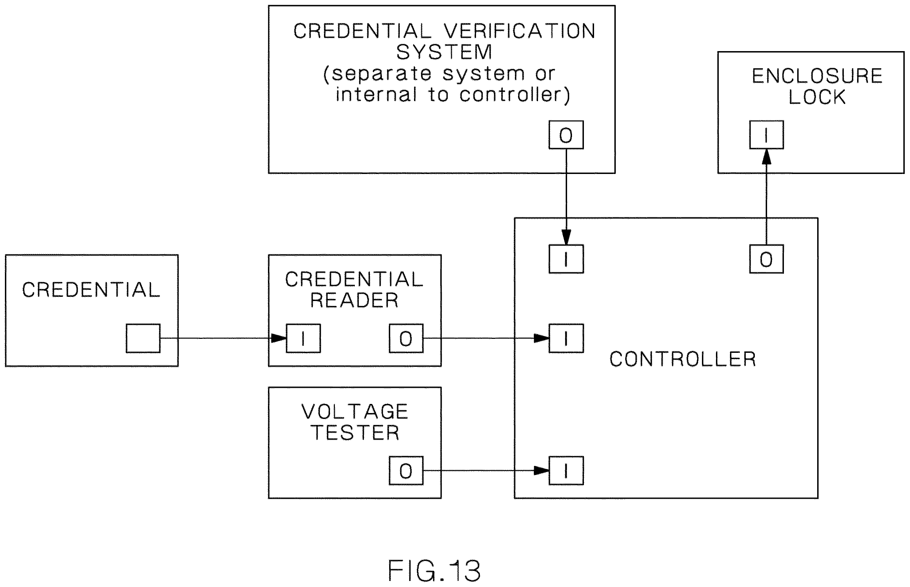

Fig. 13 shows the input and output relationship of a system with the process of Fig. 12.
Fig. 14 shows an advanced process for using status of voltage to control access to an enclosure.
Fig. 15 shows the input and output relationship os a system with the process of Fig. 14.

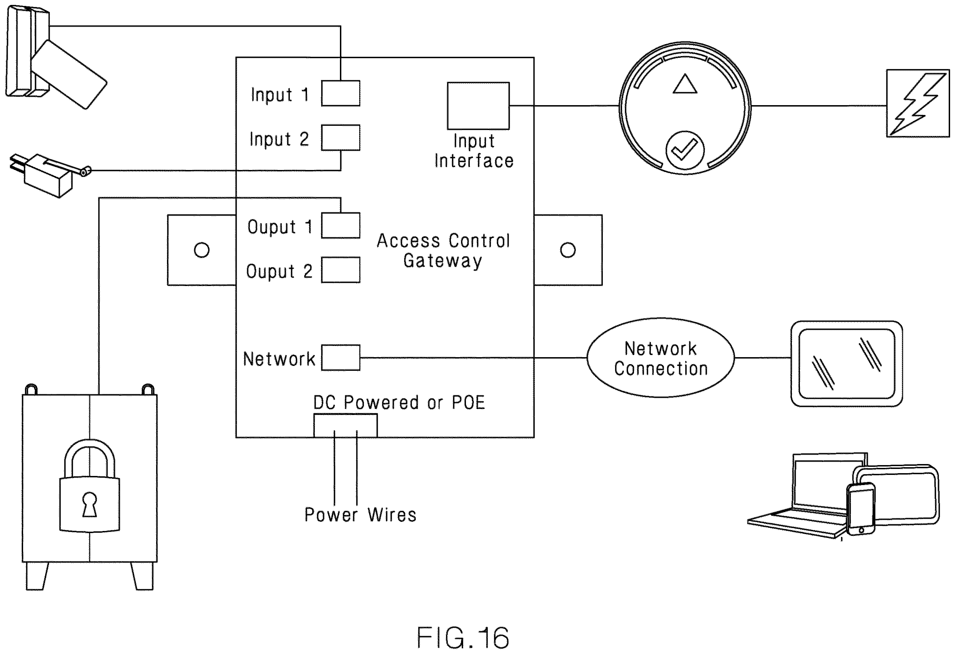

Fig. 16 shows the system elements needed to prevent access to energized electrical equipment.

### Detailed description of the Invention

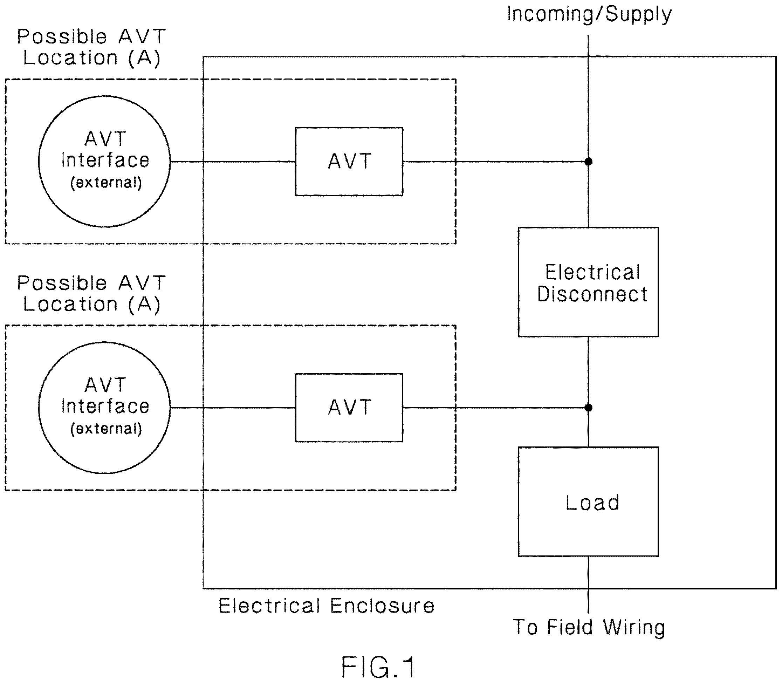

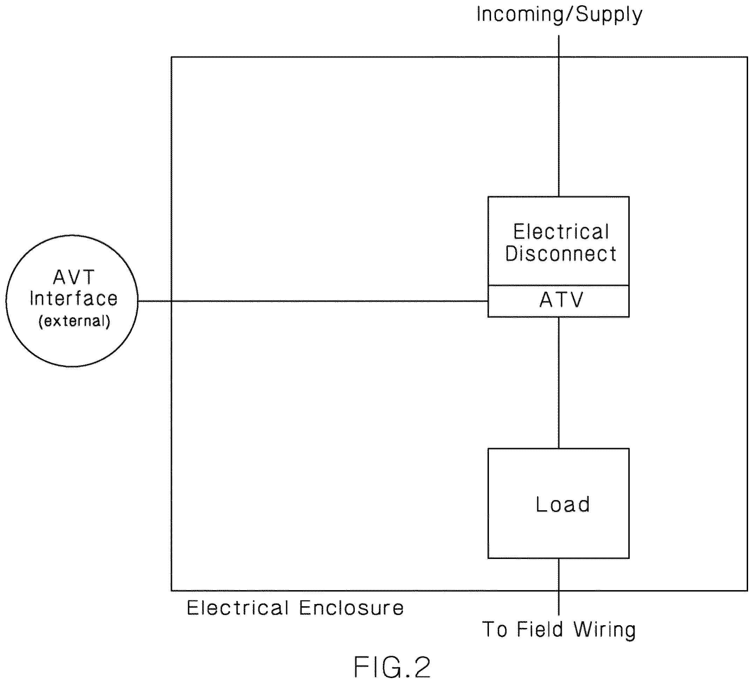

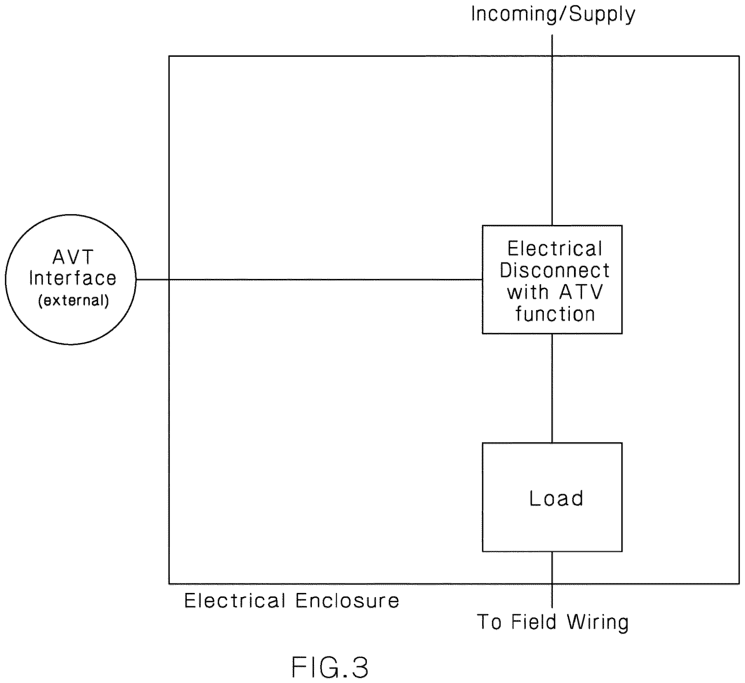

The Absence of Voltage Tester (AVT, defined in UL 1436) has been treated as a separate component in an electrical system (Fig. 1). However, there are other ways to build this technology into electrical equipment that could result in additional benefits.
1.) Add the AVT function as an accessory to an electrical component or circuit part (Figure 2). If the AVT is embodied as an accessory for an electrical component that is often a test point for absence of voltage (for example, an electrical disconnect, fused switch, circuit breaker, or component with the capability to store electrical energy), the electrical component can have built in features to optimize the footprint and installation of the AVT rather than having to connect it as a separate component. One such feature would be to incorporate two electrical taps for each phase for the AVT to connect to the point on the component where absence of voltage is being tested (typically supply side, load side, or an internal bus). Fig. 2 shows the accessory mounted on the load side, but it could also apply to the supply side. Advantages include easier mounting and installation, less wiring between components and possible space savings.
2.) Incorporate the AVT function into an electrical component or circuit part (Fig. 3). If the AVT function is may be built into the electrical component that is the test point for absence of voltage (for example, an electrical disconnect, fused switch, circuit breaker, or source of stored electrical energy). In this case the AVT circuitry would be inside the component housing eliminating the need for separate installation of the AVT inside an electrical enclosure. This arrangement may take up less physical space in the electrical enclosure. It would also ensure that all connections/terminations would be factory made, reducing installation time, increasing reliability of the terminations, and reducing the likelihood of human error being introduced during the installation/commissioning processes.

When the AVT function is built into another component, it becomes viable to automatically initiate the test when the component changes state. For example if it is a circuit breaker, switch, or contactor, when the contacts open the AVT function could automatically be triggered and the result signaled to the exterior of the enclosure.

Each of the three configurations could also leverage additional options for the external user interface portion of the AVT. For example, it could be incorporated into a HMI (human machine interface) or other portal for interaction. If the component is networked, it may be possible to initate the test remotely over the network outside of the arc flash boundary. This would result in increased personnel safety. It is still likely that there will be an external interface so that any person actually entering the equipment (or area the equipment is supplying power to such as a machine cell, robotic cell, etc.) so that they could re-verify to ensure that the equipment is the same equipment that was previously tested via the network. An arrangement of visual signaling devices, such as a pilot light or stack light, could be used to signal which equipment was remotely tested.

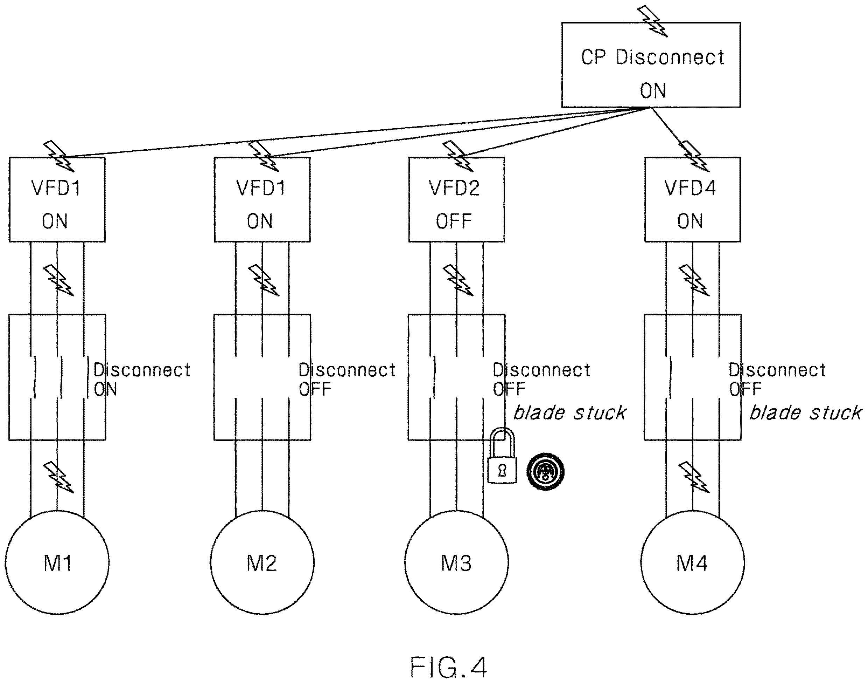

In some applications when an absence of voltage verification test is performed there may not be power present on the line side of the disconnect. In these situations, if one or more phases of the electrical disconnect mechanically fails, even though an absence of voltage test may be satisfactorily completed, if a process triggers upstream power to be applied, the area that was tested can become re-energized (see Fig. 4).

The present invention adds an additional condition to the AVT test to verify that each phase of the disconnect is open adding another layer of safety when establishing an electrically safe work condition (See Reference to NFPA 70E-2018 120.5). This product provides a way to electrically verify that a mechanical failure of the electrical disconnect did not occur before accessing or working on equipment downstream of the disconnect.

The product can be used as an optional accessory with an AVT, a product that is a combination of an AVT with an additional disconnect verification capability, or have the functionality for both the AVT and disconnect verification built into a disconnect component.

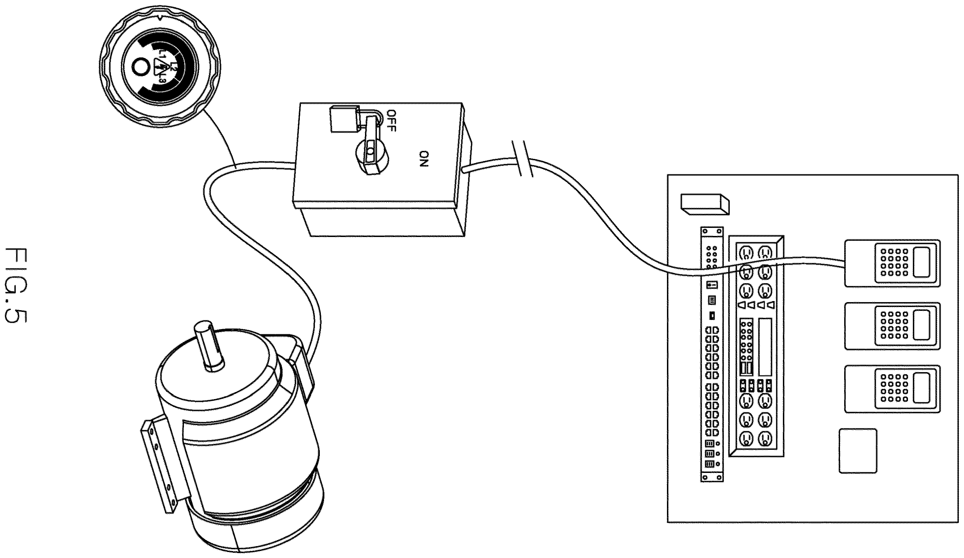

Typical applications may include:
- Remote disconnects, often downstream of a VFD/ASD and located in line of site to a motor or pump (see Fig. 5)
- Pumping stations
- Conveying systems fed by servo drives
- Rooftop HVAC units
- Welding disconnects
- Branch circuit disconnects in motor control center
- Field disconnects that are supplied by a control panel with multiple VFDs
- Complex or cascading electrical LOTO applications

The type of disconnect includes IEC rotary style disconnects and NEMA flange disconnects, including heavy duty safety switches.

To ensure an electrically safe work condition exists and that the equipment will not become energized if an upstream device is closed, after locking and tagging out the local disconnect where work will be performed best practice is to test for absence of voltage and then test for resistance across the contacts (line/load for phase A, B, and C). Similar to the advantages of an AVT when performing the absence of voltage test compared to using the portable test instrument, the reliability of electrically verifying each phase of the disconnect is open with a permanently mounted tester has several benefits: the test can be perfomed automatically, human error is reduced, and reliable test points are ensured if the tester includes an "installation test" to ensure that the test leads are in contact with a circuit part when the test is performed.

The tester can be hardwired electrically to components on both the line and load side of each phase of the disconnect being tested.

In this product, verifying the disconnect is open can involve the following steps:
- Determine that the sensor leads are connected to the circuit on both sides of each contact
- Determine the contact for each phase is open (typically A, B, and C for a three phase system)
   ∘ This concept may also apply to single phase or systems with a neutral conductor.
- Any additional diagnostics to ensure electrical and hardware performance of the device is accurate
- Signal the result via a user interface (locally at the external enclosure of the equipment, and over a network interface, if applicable)

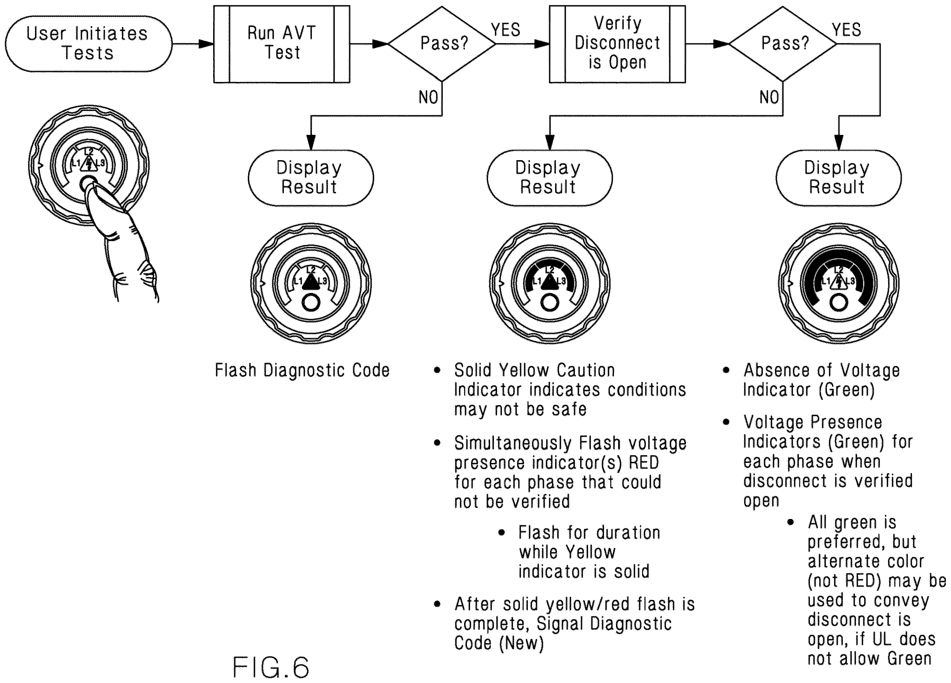

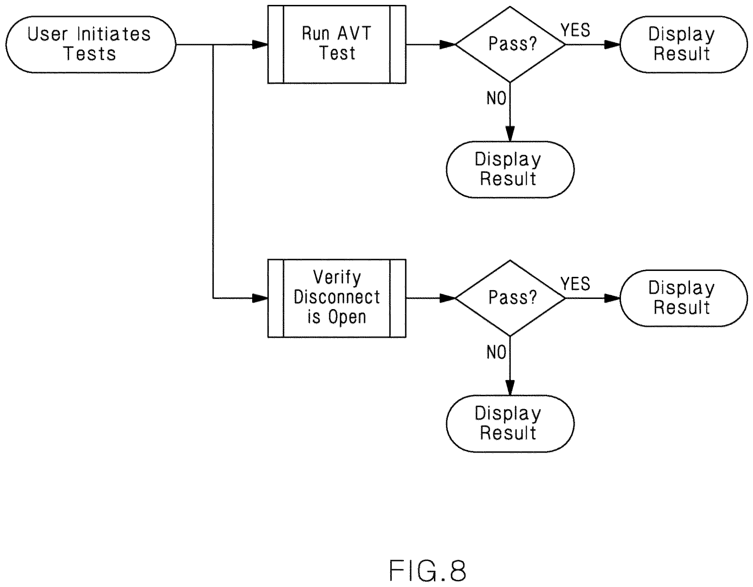

The test sequence is typically initiated by the user at the local interface, although it could also be initiated over a network, via an HMI, or by the AVT if used in combination. Two test sequences and their possible signaling results are described in Figure 6 and Figure 8. Figure 6 uses a sequential method of performing the test and adds the condition of all phases of the disconnect being opened to the criteria for a successful absence of voltage test. Figure 8 shows a parallel method of performing these two tests, and although they are initiated by the same user prompt, each test is performed and signaled independently.

Unauthorized access to an electrical, control, or network panel, whether intentional or unintentional, can lead to safety and security hazards that may affect people, equipment, or process. Using an access control system at the enclosure level that includes an electronic lock in conjunction with a credential reader users can control or restrict access to authorized people at authorized times. By powering the controller, lock, and credential reader via a non-hazardous source or energy storage device separate from the primary power (such as the network (PoE), battery, ultracap, etc.), voltage is limited to a safe level (50V or less) and the devices will continue to function as long as the secondary power is available, regardless of the status of the main/primary power sources within the enclosure. To further reduce risk, it may be desirable in some cases to further restrict access to situations only when the panel has been de-energized, or if special circumstances have been met (e.g., completion of an energized work permit).

Another method consists of a controller with input for a voltage tester and output to an electronic lock. The input and output contacts may be standard I/O, safety-rated and redundant, etc. or some combination. The voltage tester is configured to monitor the main power circuit within the enclosure. The voltage tester, lock, and controller are all powered from a non-hazardous voltage source independent of the main power circuit (this enables the devices in the system to operate even when the main power is isolated); the system components may be powered by the same source or separate sources (e.g., battery, network (PoE), etc.) The controller must have processing power to step through the logic. The user requests access to the locked enclosure by testing for voltage. If voltage is present, the enclosure remains locked. If the absence of voltage has been verified, the controller will disengage the lock for a pre-determined amount of time (for instance, 10 seconds) allowing the user to open the door before the controller re-engages the lock. When the door is closed the process can be repeated again.

Another variation is to include a form of credential authentication in the process to add additional security and prevent unauthorized personnel from accessing equipment. This is shown in 12 and 13. This method is similar to the basic process but includes an extra step to verify the identity of the user (most likely prior to checking for voltage although the sequence could be interchangeable).This additional functionality requires the controller to have two additional inputs for a credential reader (hardware installed on the exterior of the enclosure) and credential verification system. The credential verification system will typically consist of a database of credentials approved for access, external to the system linked via network from another system to the controller. However, in some cases this could be maintained within the controller. Regardless, in this variation in addition to processing ability, the controller must also contain memory to store the credentials if operating as a standalone device or should the network connection be lost. The credential reader must be powered in the same manner as the controller, voltage tester, and lock.

In this variation, the user requests access to the system by presenting his or her credentials (something that you have - badge; something that you know - PIN or password; or something that you are - biometrics) to a credential reader. The credential reader is used to authenticate the identity of the user. If the credential presented to the reader is verified by the controller as valid based on the most-recent status from the credential verification system, a test for the absence of voltage is then conducted. If voltage is not present, the lock is opened and the user is granted access. However, if the credentials are not validated or the presence of voltage is detected or undeterminable, access is denied and the lock remains engaged.

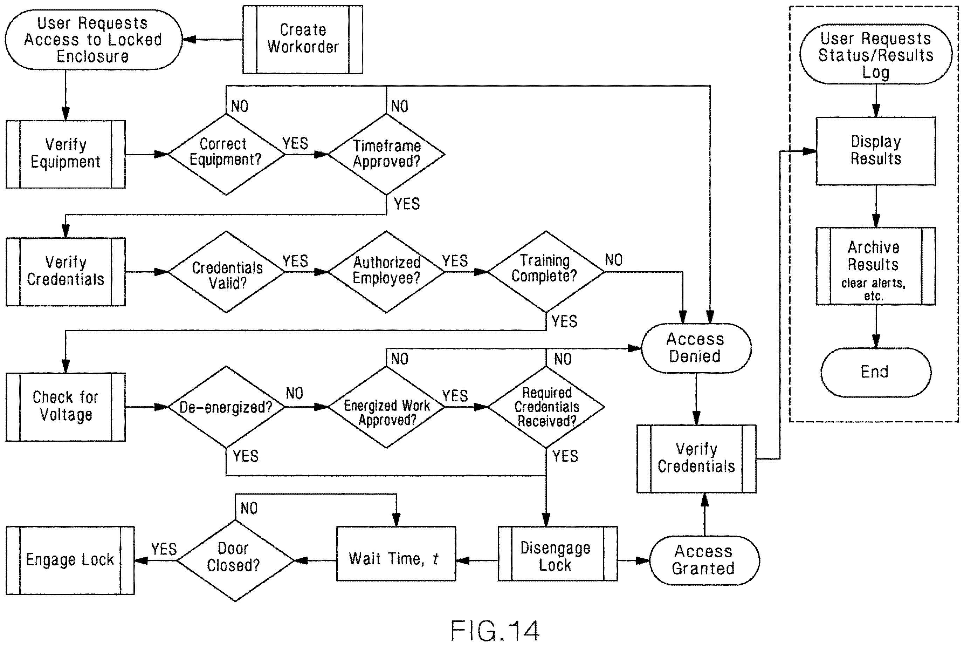

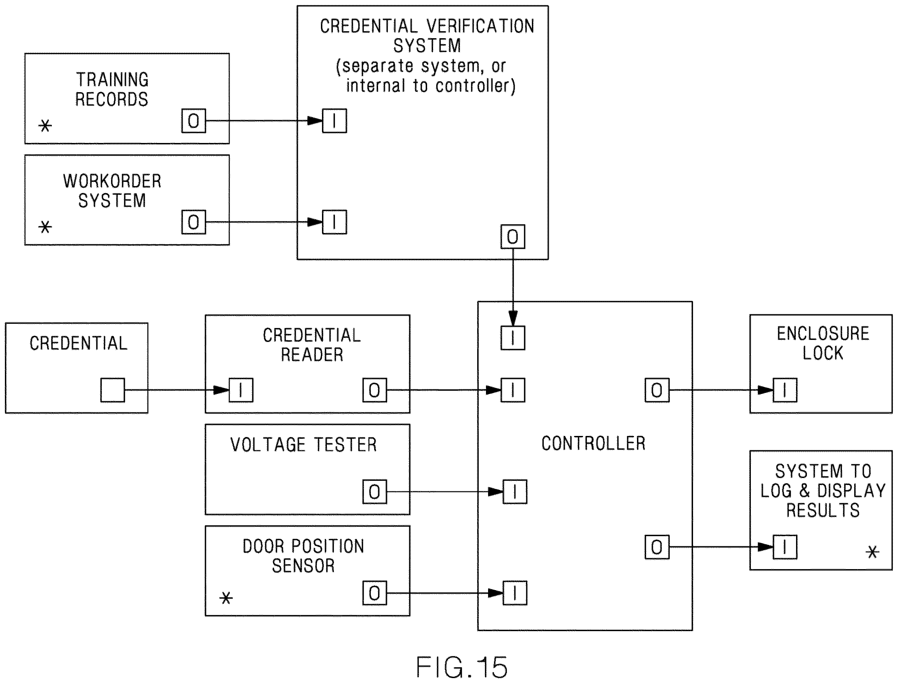

It is possible to expand upon this concept in a more complex variation with advanced features as shown in Figs 14 and 15. Depending on the desired functionality, the variation may consist of all or a subset of these features.

**The process begins by a user requesting access to an electrical panel with the elements installed as shown in** **Fig. 15****.** The user may be requesting access based on a workorder he or she received generated in an enterprise asset management system. The workorder system may be linked as an input to the controller or it may be operating independently. By integrating the workorder system, it is possible to add checks to the process to ensure that the correct equipment is being accessed and the work can be scheduled in a timeframe that is least disruptive to other processes. Verifying that the correct equipment is being accessed will help increase safety as many industrial enclosures look similar and every year incidents occur when someone accesses the wrong equipment due to improper labeling or "look-alike" features. Further, damage to surrounding equipment or process can occur if the equipment being serviced is not first shut-down properly. Particularly in process industries, this can be hazardous to people, the environment, and surroundings. Thus, being able to set a timeframe for approved access is desirable. This feature can also be used to limit access to a particular area or piece of equipment for service technicians or contractors.

Once it has been determined that the equipment attempted to be serviced was approved for access, the next step is to verify the user's credentials. The user presents his or her credentials to the reader. This process may include scanning a badge or fob, entering a PIN or password on a keypad, or presenting a fingerprint, among other methods. The system completes the process to authenticate the credentials by validating them via the credential verification system whether it is internal to the controller or linked via a separate system. This system may be linked to an active directory with a network connection to a server where credentials are stored. The credential may be further enhanced by including additional characteristics such as making sure the employee is authorized to access a particular type of equipment (for example, distinctions can be made by job role (maintenance versus office worker), or between people authorized to access high and low voltage equipment, different types of equipment such as control and automation equipment versus power distribution, equipment from a specific manufacturer, equipment in a particular zone or work cell, etc.) and cross-referencing a training database to ensure credentials are up-to-date. By integrating the credentials with training records, access can be contingent on ensuring that required classes or skill audits have been completed and documented within the system. This also sets the foundation to deliver specific need-based training on demand. For instance, prior to accessing a motor control center the user who requested access may be required to watch a brief safety video unique to a particular model of equipment or review a safety procedure.

Once credentials are validated, the controller can seek status from the voltage detector. If the voltage test determines that the equipment is de-energized, the lock can be disengaged granting the user access. However, if the panel is energized access can be denied or an additional set-of requirements can be incorporated into the controller logic to determine if access can be granted. For instance, energized work may be dependent on having additional documentation (approved energized work permit, completed job briefing, etc.) in the workorder or other linked system. Additionally, for some tasks, procedures may require more than one person to be present. The access system could be configured to require credentials from more than one user to be presented and authenticated prior to performing energized work or performing any work in a restricted area.

If all conditions have been determined satisfactory for the lock to disengage, access is granted to the enclosure. Depending on the style of lock used, the lock could engage automatically after a pre-determined period of time or it may be dependent on the position of the door. If a door position sensor is used, the controller could incorporate additional logic to determine when to send an alert or notification if the door has been open too long, if it is unexpectedly open, if it remains open when the panel is re-energized, etc. This further enhances safety and security of the overall system.

In addition to the usage already explained, another reason to implement such a system is to log and record access for energized and/or de-energized work. After access is granted or approved, the request and resulting process analysis and result can be logged. These results can then be sent as an alert or alarm if a communication mechanism is available or they could be displayed on a physical interface, for instance an HMI, mobile device, etc. Notifications of both access grants and denies are important and can be used to alert other affected personnel if work is being performed. For example, if access to energized work is approved, an alert could be sent to HMIs nearby within the arc flash boundary. Similarly, before a maintenance worker attempts to access a piece of equipment, he or she may be interested in viewing the previous access attempts and when they occurred (similar to how alarms are displayed on HMIs). The user could request to review these results via the panel HMI (or other similar visual interface); if access attempts are recent or align with when a problem began, the worker may want to get more information before beginning his work and attempting to open the panel.

The processes described herein represent three embodiments ranging from basic to advanced; one skilled in the art will recognize that there are other variations in sequence that may be just as effective or desirable based on the combination of features and functionality implemented. For example, the system could be configured to only require credentials if the system is energized in which case the voltage test would occur before the credential verification step.

The required hardware will depend on the amount of functionality desired and implemented. In the basic embodiment, the logic could be embedded in a stand-alone controller. As additional functionality is added, a networked option and/or software to provide easier management of credentials and conditions may provide a useful interface.
Network connection - to interface with databases for credentials, training records, etc. and to log access attempts, voltage test results, and time door is open, etc. (optional)
* All components powered by a non-hazardous voltage, independent from the main power - can be same for all devices (such as network power), sourced individually for each component (such as batteries), or some combination.

Any time equipment is energized, electrical shock and arc flash hazards exist; however, voltages less than 50V AC or 60V DC are generally considered safe. Utilizing a safe powered access control or enclosure "lock" could prove beneficial in the following scenarios:
- Preventing unqualified personnel from accessing an energized electrical panel, exposing hazards
- Preventing qualified personnel from opening an energized electrical panel without proper authorization, such as an energized work permit
- Preventing access to a compartment with more than one voltage source when all voltage sources are not de-energized*
- Preventing access to compartments/panels until stored energy has been dissipated to a safe level*
- Preventing access to an incorrect compartment or enclosure ( look-a-like equipment)
- Providing verification that the enclosure door or cover has been properly closed before commissioning or re-energizing equipment
- Ensuring doors and covers are properly closed and latched on arc resistant equipment
- Ensuring that qualified individuals, with proper training and access levels, are present for certain tasks (some safety procedures require two people to be present)
- Ensuring that individuals have completed all necessary training and training records are up-to-date before access is allowed to a compartment.
   *used in conjunction with voltage detection technology described in RS 16379.

In applications where each minute of downtime comes with a price tag of thousands of dollars, minimizing process disruptions is essential. Additionally, certain processes may be hazardous if not properly controlled, thus limiting access to control functions and settings can have major security and safety implications. The access control or enclosure "lock" is also applicable in the following scenarios:
- Prevent access and/or provide a record of what equipment was accessed by individuals
- Prevent unauthorized personnel from accessing equipment and provide a record of personnel who have accessed specific equipment
- Prevent access at certain times and provide a record of when equipment was accessed
- Prevent the altering of settings or parameters on the incorrect equipment, controller, or endpoint device
   ∘ Avoid errors with look-a-like equipment, providing easy identification
   ∘ Avoid changes that may be disruptive to a process at a particular time in the cycle

Monitoring and controlling access at the panel or compartment level in industrial environments has the potential to revolutionize maintenance and record keeping, especially when combined with voltage testing. As companies are facing stricter documentation requirements in regulations and codes, there is a need for product and tools that simplify compliance. The following scenarios describe how an access control or enclosure "lock" can help improve basic maintenance tasks.
- Advance maintenance practices by taking an "electronic charting" approach to industrial equipment, similar to the transition from paper to digital records in the medical and dental recordkeeping
- Ensure that personnel has the proper credentials, or role to access the equipment
- Ensure that the individual has up-to-date training on specific types of equipment
- Make access contingent to review of a schematic, work order, completion of a training model, procedure review, or checklist verification. May require link to a HMI, tablet, etc. and a database with barcodes or other means of identification on equipment and/or components.
- Create a "log file" to display history of access requests and corresponding results on HMI, mobile device, etc.

Additionally, the ability to lock out the primary power source and still access control functions could have the following benefits:
- Reduction in PPE: particularly beneficial for when PPE may limit dexterity and can create additional hazards, especially in harsh environments (extreme hot/cold, wet weather, etc.).
- No need for an energized work permit: in many companies this often requires executive approval and can be a lengthy process. Using the voltage detector as an input to the access system can help prevent workers from being exposed to energized parts
- Increased levels of safety for personnel and equipment
- Reduced incidents (avoid downtime, losses due to injury, minimize equipment replacement)
- Coupling this product with an automated documentation system can help reduce liability, by
   ∘ Proactively identifying training gaps
   ∘ Keeping maintenance records and provide warnings when tasks are due
   ∘ Providing a method to integrate maintenance and safety records
   ∘ Reducing errors from manual data entry
- Identify patterns and trends for certain equipment, personnel, or events
- Insurance incentives or reduced premiums for companies or locations

Adding intelligence, via the network capability, to voltage detection and indication systems enables additional information such as status of components related to safety to be available in real time. By adding network capability (or output contacts) to the voltage detector additional display and information activities are now possible. For instance, if switching is performed remotely, the output from the voltage detector could also be displayed via a HMI in remote locations. Additionally, if using a continuous power source (such as PoE), rather than an intermittent source, a positive indication for both the absence and presence of voltage will be displayed as long as power is available. Network capability also allows to supplement the physical interface with a more intricate display, for example indicating when voltage was last detected or more information on any other status changes.

Another embodiment could include an override code or key to allow access to the energized panel in special situations that may be required for certain applications or by qualified personnel if allowed by safety policy.

While particular embodiments and applications of the present invention have been illustrated and described, it is to be understood that the invention is not limited to the precise construction and compositions disclosed herein and that various modifications, changes, and variations may be apparent from the invention as described.

## Claims

1. A method for allowing access to an electrical enclosure having a disconnect comprising:
upon initiation by a user or upon a change of state of the disconnect automatically performing the steps of;
checking for an absence of voltage
giving a positive indication of an absence of voltage
checking the state of each phase of the electrical disconnect to ensure contacts of the disconnect are open
if there is an absence of voltage and the contacts of the disconnect are open opening, a lock on the enclosure.

2. The method of claim 1 further comprising checking credentials of a user before opening the lock of the enclosure.

## Patentansprüche

1. Verfahren zum Ermöglichen eines Zugriffs auf ein elektrisches Gehäuse mit einem Trennschalter, umfassend:
bei Initiierung durch einen Benutzer oder bei einer Zustandsänderung des Trennschalters automatisches Durchführen der folgenden Schritte;
Überprüfen auf ein Nichtanliegen von Spannung Bereitstellen einer positiven Angabe eines Nichtanliegens von Spannung
Überprüfen des Zustands jeder Phase des elektrischen Trennschalters, um sicherzustellen, dass Kontakte des Trennschalters geöffnet sind
wenn keine Spannung anliegt und die Kontakte des Trennschalters geöffnet sind
Öffnen eines Schlosses an dem Gehäuse.

2. Verfahren nach Anspruch 1, ferner umfassend Überprüfen der Berechtigung eines Benutzers, bevor das Schloss des Gehäuses geöffnet wird.

## Revendications

1. Procédé pour permettre un accès à une enceinte électrique ayant une déconnexion comprenant :
lors du lancement par un utilisateur ou lors d'un changement d'état de la déconnexion, la réalisation automatique des étapes de ;
vérification d'une absence de tension
octroi d'une indication positive d'une absence de tension vérification de l'état de chaque phase de la déconnexion électrique pour s'assurer que des contacts de la déconnexion sont ouverts
s'il y a une absence de tension et que les contacts de la déconnexion sont ouverts
ouverture d'un verrou sur l'enceinte.

2. Procédé selon la revendication 1, comprenant en outre la vérification d'accréditations d'un utilisateur avant l'ouverture du verrou de l'enceinte.
